# EUROPEAN PATENT APPLICATION

(11) **EP 2 720 120 A1**
(43) Date of publication of application: **16.04.2014**
(21) Application number: 12797316.2
(22) Date of filing: 16.04.2012
(51) Int. Cl.: G06F 3/041, G06F 3/044

(54) **INPUT DEVICE AND METHOD FOR CONTROLLING TOUCH PANEL**

(30) Priority: 10.06.2011 JP 2011130288
(71) Applicant: NEC CASIO Mobile Communications, Ltd., Kawasaki-shi, Kanagawa 211-8666 (JP)
(72) Inventor: SHIMA, Yoshikazu, Kanagawa 211-8666 (JP)
(74) Representative: Vossius & Partner
(86) International application number: PCT/JP2012/002630
(87) International publication number: WO 2012/169106

(57) **Abstract**

An input device according to the present invention includes a touch panel (1), display means (2) provided to be superimposed on the touch panel (1), measurement means (11) that is able to measure a measurement value corresponding to a situation whether a glove is worn and a thickness of the glove, and sensitivity setting means for setting sensitivity of the touch panel (1) according to the measurement value measured by the measurement means (11). The measurement value may be a value corresponding to a range in which an electrostatic capacitance of the touch panel (1) has changed, for example, and the sensitivity setting means (12) increases the sensitivity of the touch panel (1) as this value increases. It is therefore possible to provide an input device that is able to improve operability regardless of whether the glove is worn or even when a different type of glove is worn.

## Description

### Technical Field

The present invention relates to an input device and a control method of a touch panel, and more specifically, to an input device and a control method of a touch panel that can be operated even with a gloved hand.

### Background Art

More and more touch panels have been included in devices such as smartphones, and have been used in wide areas. When a user uses mobile equipment including a touch panel outdoors, for example, the user may use the mobile equipment with his or her gloved hand. Patent literature 1 discloses a technique related to a touch panel device which can normally perform ON/OFF operations regardless of whether a glove is worn or not.

According to the technique disclosed in Patent literature 1, a reference value to determine whether a user uses his or her own hand or wears a glove is specified based on a resistance value of a touch sensor when the user contacts a panel with his or her hand. When a mechanical switch is operated, the resistance value of the touch sensor that is contacted is measured, and the resistance value of the touch sensor that is measured is compared with the reference value. When the resistance value of the touch sensor is higher than the reference value, it is determined that glove is worn. In this case, a determination threshold to determine ON/OFF of the touch panel is set to be lower than a determination threshold in a case in which the user uses his or her hand to improve sensitivity of the touch panel. Meanwhile, when the resistance value of the touch sensor is lower than the reference value, it is determined that the user uses his or her hand and the determination threshold to determine ON/OFF of the touch panel is set to the determination threshold in a case in which the user uses his or her hand.

Further, Patent literature 2 discloses a technique related to an input device that includes contact object detection means that detects a contact position and a contact area between an object used when specifying a position on a screen and the screen and pointer position adjustment means that changes a distance between the contact position and the display position of a pointer according to the contact area that is detected.

In the input device disclosed in Patent literature 2, when the contact area is large, it is determined that a finger or a thick nib that is not suitable for specifying a detailed position is used. A pointer is then displayed at a position separated from the central point of the contact position. Meanwhile, when the contact area is small, a pointer is displayed at the central point of the contact position or a position in close proximity to the central point. This technique solves a problem that the pointer is hidden when a user touches the touch panel with a thick nib and a problem that the nib and the pointer are separated from each other when the user touches the touch panel with a thin nib such as a stylus.

### Citation List

### Patent Literature

**Patent literature 1:** Japanese Unexamined Patent Application Publication No. 2008-33701
**Patent literature 2:** Japanese Unexamined Patent Application Publication No. 2010-198290

### Summary of Invention

### Technical Problem

When a user operates the touch panel with a glove, a cloth or the like, which is an insulator, is interposed between a finger (skin) and the touch panel. This prevents an operation of the touch panel. In this case, by using a highly sensitive touch panel, the user is able to operate the touch panel even when he or she wears the glove. There is a problem, however, that the operation feeling of the touch panel is different and the operability is degraded depending on the type of the glove worn by the user (specifically, the thickness or the material of the glove).

The present invention has been made in view of the aforementioned problems, and an exemplary object of the present invention is to provide an input device and a control method of a touch panel that are able to improve operability regardless of whether a glove is worn or even when a different type of glove is worn.

### Solution to Problem

An input device according to the present invention includes: a touch panel; a display means provided to be superimposed on the touch panel; a measurement means that is able to measure a measurement value corresponding to a situation whether a glove is worn and a thickness of the glove; and a sensitivity setting means configured to set sensitivity of the touch panel according to the measurement value measured by the measurement means.

A control method of a touch panel according to the present invention includes: measuring a measurement value corresponding to a situation whether a glove is worn and a thickness of the glove, and setting sensitivity of the touch panel according to the measurement value that is measured.

### Advantageous Effects of Invention

According to the present invention, it is possible to provide an input device and a control method of a touch panel that are able to improve operability regardless of whether a glove is worn or even when a different type of glove is worn.

### Brief Description of Drawings

Fig. 1 is a block diagram showing an input device according to a first exemplary embodiment;
Fig. 2 is a diagram showing one example when a range in which an electrostatic capacitance of a touch panel has changed is approximated by a circle in the input device according to the first exemplary embodiment;
Fig. 3A is a cross-sectional view for describing a case in which a measurement value is measured when a user uses his or her own hand in the input device according to the first exemplary embodiment;
Fig. 3B is a cross-sectional view for describing a case in which the measurement value is measured when the user wears a glove (thin one) in the input device according to the first exemplary embodiment;
Fig. 3C is a cross-sectional view for describing a case in which the measurement value is measured when the user wears a glove (thick one) in the input device according to the first exemplary embodiment;
Fig. 4 is a diagram for describing a case in which the touch panel and a finger are in proximity to each other;
Fig. 5 is a flowchart for describing an operation of the input device according to the first exemplary embodiment;
Fig. 6 is a diagram showing a relation between a radius of a circle and sensitivity of the touch panel when the range in which the electrostatic capacitance of the touch panel has changed is approximated by the circle;
Fig. 7 is a flowchart for describing an operation of the input device according to the first exemplary embodiment;
Fig. 8 is a diagram showing specific examples of screens of the input device according to the first exemplary embodiment;
Fig. 9 is a block diagram showing an input device according to a second exemplary embodiment;
Fig. 10 is a flowchart for describing an operation of the input device according to the second exemplary embodiment;
Fig. 11 is a diagram showing one example of an icon used in the input device according to the second exemplary embodiment;
Fig. 12 is a diagram showing specific examples of screens of the input device according to the second exemplary embodiment;
Fig. 13 is a block diagram showing an input device according to a third exemplary embodiment;
Fig. 14 is a diagram showing a relation between a size of a guide display and a distance (h) between a touch panel and a finger;
Fig. 15A is a diagram showing specific examples of screens of the input device according to the third exemplary embodiment, and shows a case in which the distance between the touch panel and the finger is long;
Fig. 15B is a diagram showing a specific example of the screen of the input device according to the third exemplary embodiment, and shows a case in which the distance between the touch panel and the finger is short;
Fig. 16 is a block diagram showing an input device according to a fourth exemplary embodiment;
Fig. 17A is a diagram showing pointers in the input device according to the fourth exemplary embodiment, and shows a case in which a touch panel and a gloved finger are in contact with each other; and
Fig. 17B is a diagram showing pointers in the input device according to the fourth exemplary embodiment, and shows a case in which a distance between the touch panel and the gloved finger is long.

### Description of Embodiments

### First exemplary embodiment

Hereinafter, with reference to the drawings, exemplary embodiments of the present invention will be described.

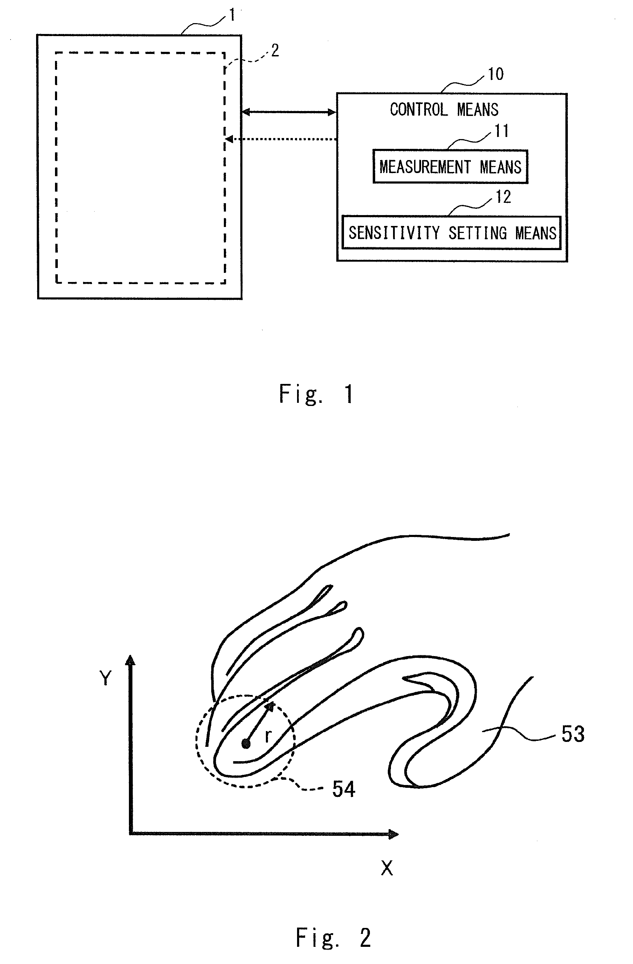

Fig. 1 is a block diagram showing an input device according to a first exemplary embodiment of the present invention. The input device according to this exemplary embodiment includes a touch panel 1, display means 2, and control means 10.

The touch panel 1 is, for example, an electrostatic capacitance touch panel, and in the input device according to this exemplary embodiment, may be a projection-type electrostatic capacitance touch panel. The projection-type electrostatic capacitance touch panel may be formed by forming a number of transparent electrode patterns in mosaic extending in a vertical direction and a lateral direction on a substrate made of glass, plastic or the like, and further forming an insulation film on the transparent electrode patterns. In the projection-type electrostatic capacitance touch panel, changes in an electrostatic capacitance of the insulation film which is on the surface of the touch panel, the changes occurring when a person's finger comes in contact or approaches the touch panel, are detected using the transparent electrode patterns, thereby being able to specify the position of the person's finger.

The display means 2 is provided to be superimposed on the touch panel 1. Specifically, the touch panel 1 is provided on the display means 2 (i.e., the touch panel 1 is externally exposed). The touch panel 1 is transparent, and images or video displayed on the display means 2 are displayed through the touch panel 1. The display means 2 is, for example, a liquid crystal display, an organic EL display or the like. However, it is not limited to them.

The control means 10 controls the touch panel 1 and the display means 2. More specifically, the control means 10 detects an operation input by a user using changes in the electrostatic capacitance in the touch panel 1, and outputs information regarding this operation to another circuit such as a processing device (not shown). Further, the control means 10 outputs display data or the like to the display means 2.

The control means 10 includes measurement means 11 and sensitivity setting means 12. The measurement means 11 is able to measure a measurement value corresponding to a situation whether a glove is worn and the thickness of the glove. The measurement value corresponding to a situation whether a glove is worn and the thickness of the glove is a value (first value) corresponding to a range in which the electrostatic capacitance of the touch panel 1 has changed when a person touches the touch panel with his or her hand or a gloved finger. Alternatively, a radius or a diameter of a circle when the range in which the electrostatic capacitance of the touch panel 1 has changed is approximated by the circle may be used as the measurement value corresponding to the situation whether a glove is worn and the thickness of the glove. Further alternatively, a maximum value of the electrostatic capacitance generated in the touch panel 1 when a person touches the touch panel with his or her hand or a gloved finger may be used as the measurement value corresponding to the situation whether a glove is worn and the thickness of the glove.

Fig. 2 is a diagram showing one example of a case in which the range in which the electrostatic capacitance of the touch panel has changed is approximated by the circle in the input device according to this exemplary embodiment. As shown in Fig. 2, when a user touches the touch panel 1 with his or her hand or with a gloved finger 53, there is a change in the electrostatic capacitance in a predetermined range of the touch panel. Since the surface on which the hand or the gloved finger 53 is in contact with the touch panel 1 is substantially circular, the contact surface can be approximated by a circle 54. At this time, a radius r or a diameter of this circle 54 can be used as the measurement value corresponding to the situation whether a glove is worn and the thickness of the glove.

The sensitivity setting means 12 sets sensitivity of the touch panel 1 according to the measurement value measured by the measurement means 11. More specifically, when the measurement value measured by the measurement means 11 indicates that the finger which touches the touch panel 1 is a hand, the sensitivity measurement means 12 sets the sensitivity of the touch panel 1 to a regular mode. Meanwhile, when the measurement value measured by the measurement means 11 indicates that the finger which touches the touch panel 1 is a gloved finger, the sensitivity measurement means 12 sets the sensitivity of the touch panel 1 to a high-sensitivity mode, which is more sensitive than the regular mode. The sensitivity measurement means 12 is further able to set the sensitivity to a low level, a medium level, and a high level in the high-sensitivity mode according to the measurement value measured by the measurement means 11. The sensitivity levels increase in the order of the regular mode, the low level of the high-sensitivity mode, the medium level of the high-sensitivity mode, and the high level of the high-sensitivity mode. The sensitivity levels may be set in more detail.

In other words, the sensitivity setting means 12 is able to increase the sensitivity of the touch panel 1 with increasing value corresponding to the range in which the electrostatic capacitance of the touch panel 1 has changed. Further, the sensitivity setting means 12 is able to increase the sensitivity of the touch panel 1 as the radius or the diameter of the circle when the range in which the electrostatic capacitance of the touch panel 1 has changed is approximated by the circle increases. Further, the sensitivity setting means 12 is able to increase the sensitivity of the touch panel 1 with decreasing value corresponding to the maximum value of the electrostatic capacitance of the touch panel 1.

Further, the sensitivity setting means 12 sets the sensitivity of the touch panel 1 to the high-sensitivity mode when the measurement means 11 measures the measurement value.

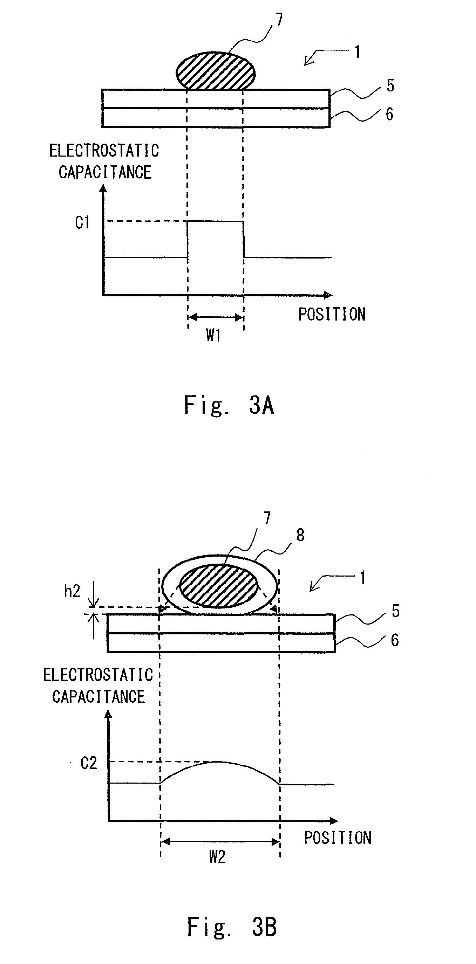

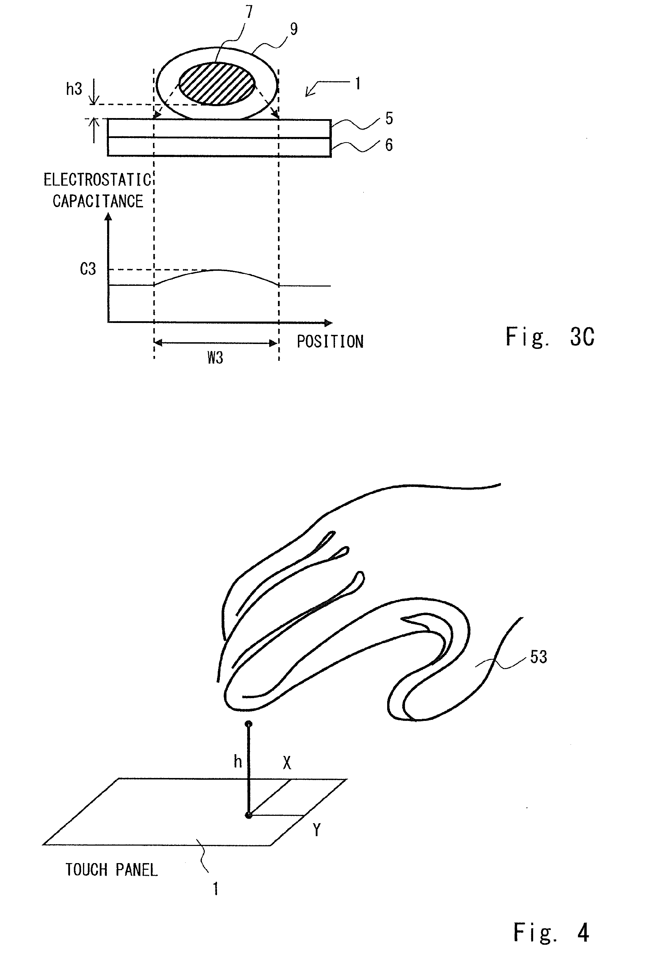

Next, with reference to Figs. 3A to 3C, the measurement value corresponding to the situation whether a glove is worn and the thickness of the glove measured by the measurement means 11 will be described. The touch panel 1 shown in Figs. 3A to 3C includes an insulation film 5 and a transparent electrode pattern layer 6. Fig. 3A is a cross-sectional view when a person touches the touch panel 1 with a hand 7, Fig. 3B is a cross-sectional view when the person touches the touch panel 1 with a glove (thin one) 8 on the hand 7, and Fig. 3C is a cross-sectional view when the person touches the touch panel 1 with a glove (thick one) 9 on the hand 7.

As shown in Fig. 4, when the touch panel 1 and the hand or the gloved finger 53 are in proximity to each other, the position at which the value of the electrostatic capacitance of the touch panel 1 (i.e., insulation film 5) becomes maximum can be specified with X-Y coordinates on the touch panel 1. In this case, the distance between the position at which the value of the electrostatic capacitance of the touch panel 1 becomes maximum and the hand or the gloved finger 53 is indicated as a distance h.

As shown in Fig. 3A, when the person touches the touch panel 1 with the hand 7, the range in which the electrostatic capacitance of the insulation film 5 has changed corresponds to a range of a width W1. At this time, the maximum value of the electrostatic capacitance is an electrostatic capacitance C1. In this case, since the hand 7 directly touches the insulation film 5 of the touch panel 1, the electrostatic capacitance C1, which is the maximum value of the electrostatic capacitance, is larger than that in the case in which the user wears the glove as shown in Figs. 3B and 3C.

Further, when the person touches the touch panel 1 with the glove (thin one) 8 on the hand 7 as shown in Fig. 3B, the range in which the electrostatic capacitance of the insulation film 5 has changed corresponds to a range of a width W2. At this time, the maximum value of the electrostatic capacitance is an electrostatic capacitance C2. In this case, since the user wears the glove 8, the glove with a thickness h2, which is an insulator, is interposed between the insulation film 5 and the hand 7. The range in which the electrostatic capacitance changes on the surface of the insulation film 5 is therefore W2, which is larger than W1. This is because, since the hand 7 and the insulation film 5 are separated by the distance h2, an electric field between the hand 7 and the insulation film 5 is spread. Meanwhile, since the hand 7 and the insulation film 5 are separated by the distance h2, the maximum value of the electrostatic capacitance of the insulation film 5 is the electrostatic capacitance C2, which is smaller than the electrostatic capacitance C1.

Further, when the person touches the touch panel 1 with the glove (thick one) 9 on the hand 7 as shown in Fig. 3C, the range in which the electrostatic capacitance of the insulation film 5 has changed corresponds to a range of a width W3. At this time, the maximum value of the electrostatic capacitance is an electrostatic capacitance C3. In this case, since the user wears the glove 9, the glove with a thickness h3, which is an insulator, is interposed between the insulation film 5 and the hand 7. The range in which the electrostatic capacitance changes on the surface of the insulation film 5 is therefore W3, which is larger than W2. This is because, since the hand 7 and the insulation film 5 are separated by the distance h3, an electric field between the hand 7 and the insulation film 5 is spread. Meanwhile, since the hand 7 and the insulation film 5 are separated by the distance h3, the maximum value of the electrostatic capacitance of the insulation film 5 is the electrostatic capacitance C3, which is smaller than the electrostatic capacitance C2.

In summary, in the examples shown in Figs. 3A to 3C, the values of the electrostatic capacitances (maximum values) decrease in the order of the electrostatic capacitance C1 when the person touches the touch panel 1 with the hand 7, the electrostatic capacitance C2 when the person touches the touch panel 1 with the glove (thin one) 8 on the hand 7, and the electrostatic capacitance C3 when the person touches the touch panel 1 with the glove (thick one) 9 on the hand 7. Further, the range in which the electrostatic capacitance of the insulation film 5 has changed increases in the order of the case in which the person touches the touch panel 1 with the hand 7 (width W1), the case in which the person touches the touch panel 1 with the glove (thin one) 8 on the hand 7 (width W2), and the case in which the person touches the touch panel 1 with the glove (thick one) 9 on the hand 7 (W3).

While the range in which the electrostatic capacitance of the insulation film 5 has changed is shown by the widths W1 to W3 in the cross-sectional views in Figs. 3A to 3C, the values of the widths W1 to W3 each correspond to the range (area) in which the electrostatic capacitance of the touch panel 1 changes when a person touches the touch panel with his or her hand or a gloved finger. Further, the values of the widths W1 to W3 each correspond to the radius or the diameter of the circle when the range in which the electrostatic capacitance of the touch panel 1 has changed is approximated by the circle. In short, such a relation is established in which the value of the radius or the diameter of the circle when the range in which the electrostatic capacitance of the touch panel 1 has changed is approximated by the circle increases with increasing values of the widths W1 to W3.

Hereinafter, a state in which the hand 7 is in touch with the touch panel 1 as shown in Fig. 3A is expressed as "in contact". On the other hand, a state in which the hand 7 is not in contact with the touch panel 1 but is close to the touch panel 1 is expressed as "in proximity". Further, the state in which the distance between the hand 7 and the touch panel 1 is h2 in the state in which the hand 7 with the glove 8 is in touch with the touch panel 1 as shown in Fig. 3B, i.e., the state in which the glove 8 is in touch with the touch panel 1 (in this case, the glove 8 is interposed between the hand 7 and the touch panel 1) is expressed as "in contact". Meanwhile, the state in which the distance between the hand 7 and the touch panel 1 is larger than h2 in the state in which the hand 7 with the glove 8 is not in contact with the touch panel 1, i.e., the state in which the glove 8 is not in contact with the touch panel 1 (in this case, there is a space between the hand 7 and the touch panel 1) is expressed as "in proximity". The same holds true for Fig. 3C.

In the input device according to this exemplary embodiment, by changing the sensitivity of the touch panel, it is possible to set the distance between the hand 7 and the touch panel 1 (corresponding to the thickness of the glove) so that the touch panel recognizes the "contact". Specifically, in the case of Fig. 3B, the sensitivity of the touch panel is set so that the touch panel 1 recognizes the contact state when the distance between the hand 7 and the touch panel 1 (corresponding to the thickness of the glove 8) is h2. In the similar way, in the case of Fig. 3C, the sensitivity of the touch panel is set so that the touch panel 1 recognizes the contact state when the distance between the hand 7 and the touch panel 1 (corresponding to the thickness of the glove 9) is h3. Accordingly, the user who uses the touch panel is able to obtain the similar operation feeling even when a different type of glove is worn.

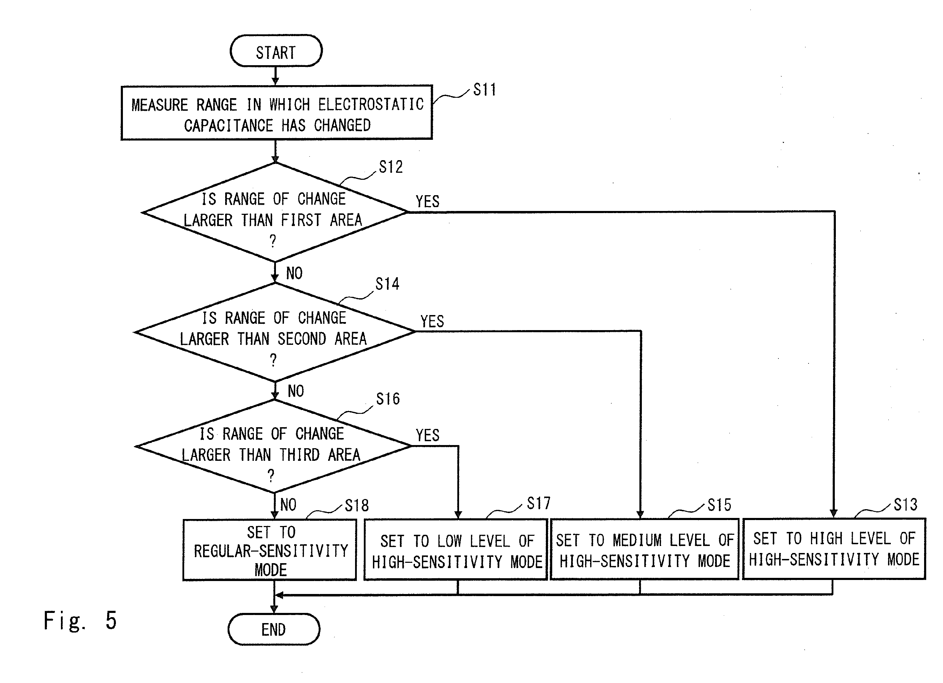

Next, with reference to a flowchart shown in Fig. 5, an operation of the input device according to this exemplary embodiment will be described. In the example shown in Fig. 5, a case is shown in which the measurement means 11 measures the range (area) in which the electrostatic capacitance of the touch panel 1 has changed when a person touches the touch panel with his or her hand or a gloved finger.

First, the measurement means 11 measures the range in which the electrostatic capacitance of the touch panel 1 has changed when a person touches the touch panel with his or her hand or a gloved finger (Step S11). When the range in which the electrostatic capacitance has changed is larger than a first area (Step S12: YES), the sensitivity measurement means 12 sets the sensitivity of the touch panel 1 to the "high level of the high-sensitivity mode" (Step S13). In this case, since the user wears a relatively thick glove on the hand 7, the sensitivity of the touch panel 1 is set to the "high level of the high-sensitivity mode", which is the highest level.

When the range in which the electrostatic capacitance has changed is equal to or smaller than the first area (Step S12: NO) and is further larger than a second area (Step S14: YES), the sensitivity measurement means 12 sets the sensitivity of the touch panel 1 to the "medium level of the high-sensitivity mode" (Step S15).

When the range in which the electrostatic capacitance has changed is equal to or smaller than the second area (Step S14: NO) and is further larger than a third area (Step S16: YES), the sensitivity measurement means 12 sets the sensitivity of the touch panel 1 to the "low level of the high-sensitivity mode" (Step S17).

When the range in which the electrostatic capacitance has changed is equal to or smaller than the third area (Step S16: NO), the sensitivity measurement means 12 sets the sensitivity of the touch panel 1 to the "regular-sensitivity mode" (Step S18).

In the example shown in Fig. 5, when the finger which operates the touch panel is a gloved finger, the sensitivity measurement means 12 sets the sensitivity of the touch panel so that the sensitivity of the touch panel increases with increasing thickness of the glove worn by the user (Steps S 13, S 15, and S17). Meanwhile, when the finger which operates the touch panel is a hand (the case in which the user does not wear a glove), the sensitivity measurement means 12 sets the sensitivity of the touch panel to the regular-sensitivity mode (Step S 18). The first to third areas are values that decrease in the order of the first area, the second area, and the third area, and these values can be determined as appropriate according to specifications.

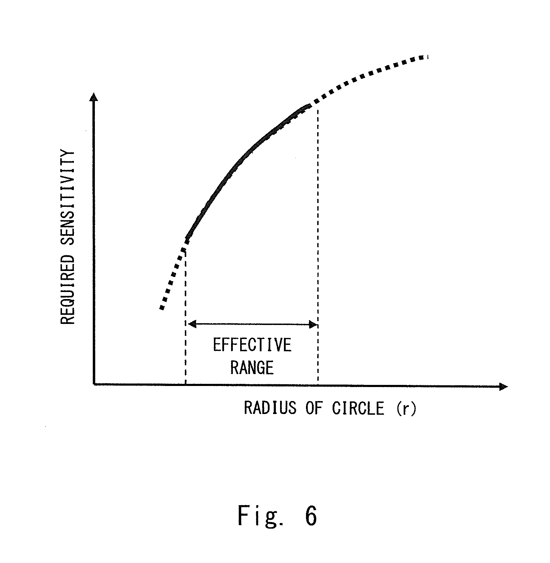

Further, in the case in which the radius r when the contact surface is approximated by the circle is used, for example, as a value corresponding to the range in which the electrostatic capacitance of the touch panel 1 has changed (see Fig. 2), as shown in Fig. 6, sensitivity required by the touch panel 1 increases with increasing radius r of the circle. Specifically, as the radius of the circle increases, the range in which the electrostatic capacitance has changed increases, the distance between the touch panel 1 and the hand or the gloved finger increases, and the sensitivity required by the touch panel 1 increases. When the radius of the circle is equal to or larger than a predetermined value, it is impossible to operate the touch panel.

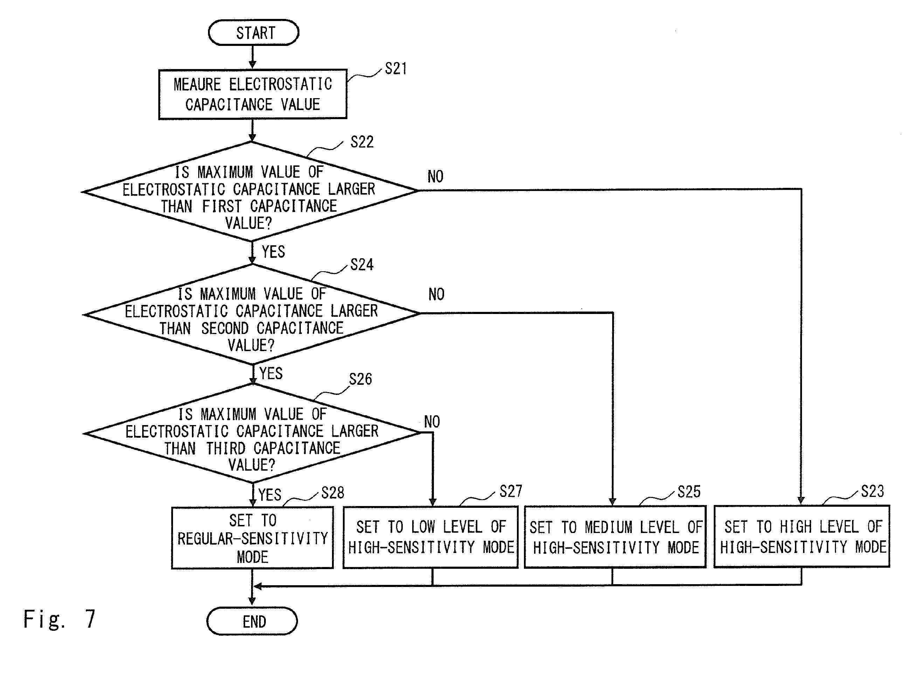

Next, with reference to a flowchart shown in Fig. 7, an operation of the input device according to this exemplary embodiment will be described. In the example shown in Fig. 7, a case is shown in which the maximum value of the electrostatic capacitance of the touch panel 1 is measured by the measurement means 11 when a person touches the touch panel with his or her hand or a gloved finger.

First, when the person touches the touch panel with his or her hand or a gloved finger, the measurement means 11 measures the maximum value of the electrostatic capacitance of the touch panel 1 (Step S21). When the maximum value of the electrostatic capacitance is equal to or smaller than a first capacitance value (Step S22: NO), the sensitivity measurement means 12 sets the sensitivity of the touch panel 1 to the "high level of the high-sensitivity mode" (Step S23). In summary, in this case, since the user wears a relatively thick glove on the hand 7, the sensitivity of the touch panel 1 is set to the "high level of the high-sensitivity mode", which is the highest level.

When the maximum value of the electrostatic capacitance is larger than the first capacitance value (Step S22: YES) and is further equal to or smaller than a second capacitance value (Step S24: NO), the sensitivity measurement means 12 sets the sensitivity of the touch panel 1 to the "medium level of the high-sensitivity mode" (Step S25).

When the maximum value of the electrostatic capacitance is larger than the second capacitance value (Step S24: YES) and is further equal to or smaller than a third capacitance value (Step S26: NO), the sensitivity measurement means 12 sets the sensitivity of the touch panel 1 to the "low level of the high-sensitivity mode" (Step S27).

When the maximum value of the electrostatic capacitance is larger than the third capacitance value (Step S26: YES), the sensitivity measurement means 12 sets the sensitivity of the touch panel 1 to the "regular-sensitivity mode (Step S28).

Also in the case shown in Fig. 7, the sensitivity measurement means 12 sets the sensitivity of the touch panel so that it increases with increasing thickness of the glove worn by the user when the finger which operates the touch panel is a gloved finger (Steps S23, S25, and S27). At this time, the maximum value of the electrostatic capacitance decreases with increasing thickness of the glove worn by the user. Meanwhile, when the finger which operates the touch panel is a hand (the case in which the user does not wear a glove), the sensitivity measurement means 12 sets the sensitivity of the touch panel to the regular-sensitivity mode (Step S28). The first to third capacitance values above are values that increase in the order of the first capacitance value, the second capacitance value, and the third capacitance value, and these values may be determined as appropriate according to specifications.

When a user operates the touch panel with a glove, a cloth or the like, which is an insulator, is interposed between a finger (skin) and the touch panel. This prevents an operation of the touch panel. In this case, by using a highly sensitive touch panel, the user is able to operate the touch panel even when he or she wears the glove. There is a problem, however, that the operation feeling of the touch panel changes and the operability is degraded depending on the type of the glove (more specifically, the thickness or the material of the glove).

In the input device according to this exemplary embodiment, the measurement means 11 measures the measurement value corresponding to the situation whether a glove is worn and the thickness of the glove, and the sensitivity setting means 12 sets the sensitivity of the touch panel 1 according to the measurement value measured by the measurement means 11, thereby being able to set the sensitivity of the touch panel 1 to an optimal state and to improve the operability of the input device.

In summary, in the input device according to this exemplary embodiment, by changing the sensitivity of the touch panel, it is possible to set the distance between the hand 7 and the touch panel 1 (corresponding to the thickness of the glove) so that the touch panel recognizes the "contact" (see Figs. 3A to 3C). Accordingly, the user who uses the touch panel is able to obtain the similar operation feeling even when a different type of glove is worn.

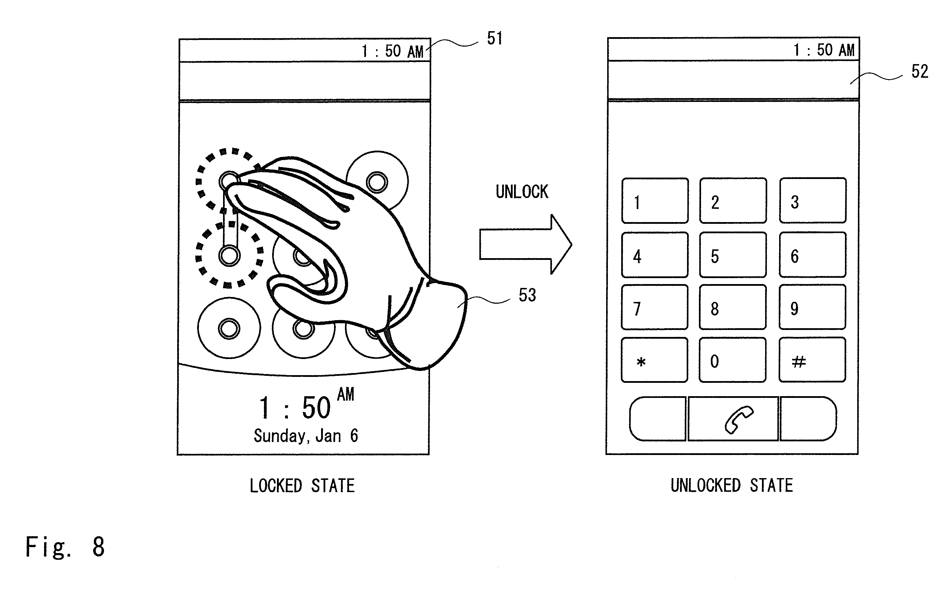

Fig. 8 is a diagram showing specific examples of screens of the input device according to this exemplary embodiment. A screen 51 shows a locked state in which a key operation is invalid, and a screen 52 shows an unlocked state. Fig. 8 shows a case in which a user operates the touch panel with the glove 53 on a finger. In order to unlock the screen 51, the user needs to input a password or a pattern to unlock the screen using the touch panel. When the password or the pattern that is input is correct, the input device is unlocked and the state changes to the state of the screen 52.

In the input device according to this exemplary embodiment, the measurement means 11 may measure the measurement value corresponding to the situation whether a glove is worn and the thickness of the glove when an operation is executed to release the locked state in which the input from the touch panel 1 is locked. When the input device is portable equipment, the location at which the input device is used frequently changes from indoors to outdoors or vice versa. In the input device according to this exemplary embodiment, every time the operation of releasing the locked state is executed, the measurement means 11 measures the measurement value corresponding to the situation whether a glove is worn and the thickness of the glove, and the sensitivity setting means 12 sets the sensitivity of the touch panel 1 according to the measurement value measured by the measurement means 11, thereby being able to set the sensitivity of the touch panel 1 to an optimal state every time the input device is used and to improve the operability of the input device.

According to the invention in the exemplary embodiment described above, it is possible to provide an input device and a control method of a touch panel capable of improving operability regardless of whether a glove is worn or even when a different type of glove is worn.

### Second exemplary embodiment

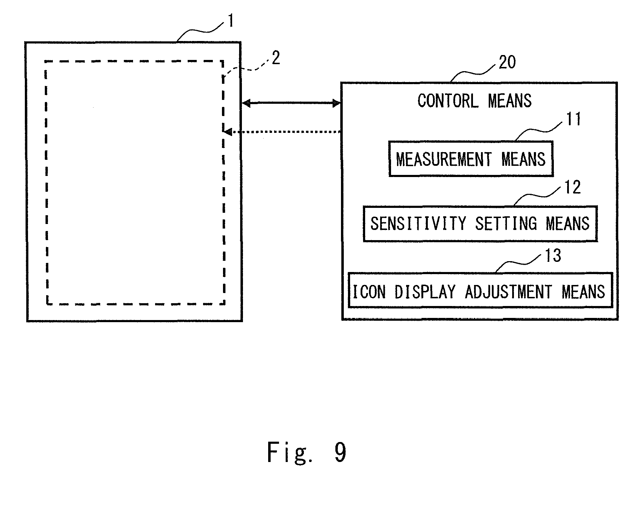

Next, a second exemplary embodiment according to the present invention will be described. Fig. 9 is a block diagram showing an input device according to this exemplary embodiment. The input device according to this exemplary embodiment is different from the input device according to the first exemplary embodiment in that a control means 20 according to this exemplary embodiment includes an icon display adjustment means 13. Other components are similar to those in the input device according to the first exemplary embodiment, and thus the same components are denoted by the same reference symbols and overlapping description will be omitted.

When the touch panel 1 is operated with a gloved finger, the area of the tip part of the gloved finger increases, which causes a problem that an icon displayed on the display means 2 is hidden by the glove and the operability is degraded. In order to solve this problem, the input device according to this exemplary embodiment uses the icon display adjustment means 13 to adjust the size of the icon displayed on the display means 2 according to the measurement value measured by the measurement means 11.

When the measurement value measured by the measurement means 11 is the value corresponding to the range in which the electrostatic capacitance of the touch panel 1 has changed, for example, the icon display adjustment means 13 may adjust the size of the icon so that the size of the icon displayed on the display means 2 increases with increasing value corresponding to the range in which the electrostatic capacitance of the touch panel 1 has changed.

Furthermore, for example, the icon display adjustment means 13 may adjust the size of the icon so that the area of the icon becomes larger than the area of the circle when the range in which the electrostatic capacitance of the touch panel 1 has changed is approximated by the circle.

Furthermore, for example, when the measurement value measured by the measurement means 11 is the value corresponding to the maximum value of the electrostatic capacitance of the touch panel 1, the icon display adjustment means 13 may adjust the size of the icon so that the size of the icon displayed on the display means 2 increases with decreasing value corresponding to the maximum value of the electrostatic capacitance of the touch panel 1.

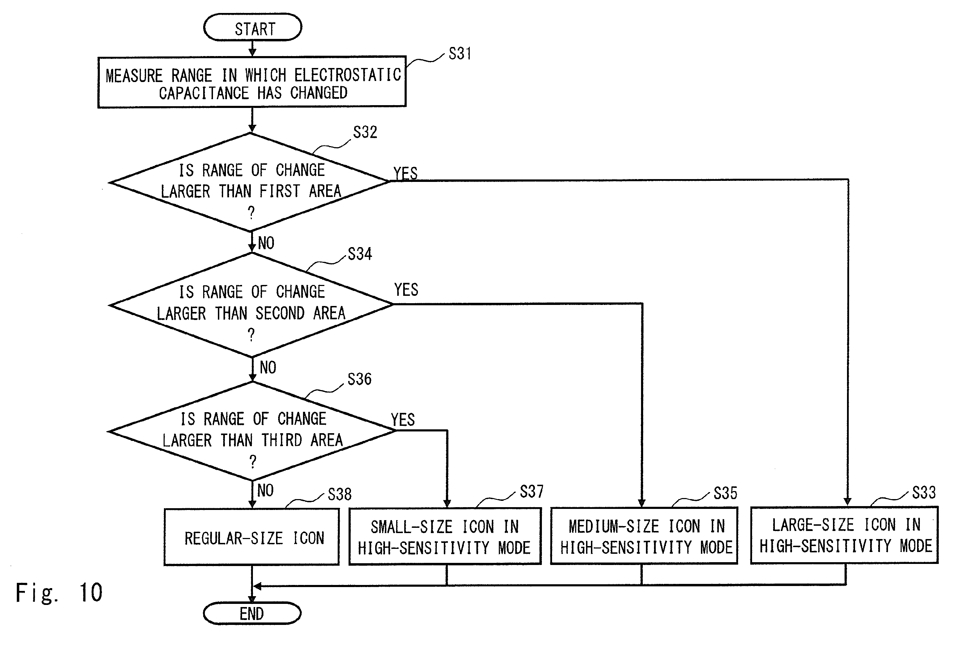

Next, with reference to a flowchart shown in Fig. 10, an example of an operation of the input device according to this exemplary embodiment will be described. The example shown in Fig. 10 shows a case in which the measurement means 11 measures the range in which the electrostatic capacitance of the touch panel 1 has changed when a person touches the touch panel with his or her hand or a gloved finger.

First, the measurement means 11 measures the range in which the electrostatic capacitance of the touch panel 1 has changed when the person touches the touch panel with his or her hand or a gloved finger (Step S31). When the range in which the electrostatic capacitance has changed is larger than a first area (Step S32: YES), the icon display adjustment means 13 sets the icon displayed on the display means 2 to the "large-size icon in the high-sensitivity mode" (Step S33). Specifically, in this case, since the user wears a relatively thick glove on the hand 7, the icon displayed on the display means 2 is set to the "large-size icon in the high-sensitivity mode", which is the largest size.

When the range in which the electrostatic capacitance has changed is equal to or smaller than the first area (Step S32: NO) and is further larger than a second area (Step S34: YES), the icon display adjustment means 13 sets the icon displayed on the display means 2 to the "medium-size icon in the high-sensitivity mode" (Step S35).

When the range in which the electrostatic capacitance has changed is equal to or smaller than the second area (Step S34: NO) and is further larger than a third area (Step S36: YES), the icon display adjustment means 13 sets the icon displayed on the display means 2 to the "small-size icon in the high-sensitivity mode" (Step S37).

When the range in which the electrostatic capacitance has changed is equal to or smaller than the third area (Step S36: NO), the icon display adjustment means 13 sets the size of the icon displayed on the display means 2 to the "regular-size icon" (Step S38).

In the example shown in Fig. 10, the icon display adjustment means 13 sets the size of the icon displayed on the display means 2 so that it increases with increasing thickness of the glove when the finger which operates the touch panel 1 is a gloved finer (Steps S33, S35, and S37). It is therefore possible to suppress such a situation in which the area of the gloved finger tip increases with increasing thickness of the glove and the icon displayed on the display means 2 is hidden. On the other hand, the icon display adjustment means 13 sets the size of the icon displayed on the display means 2 to the regular-size icon when the finger which operates the touch panel is a hand (the case in which the user does not wear a glove) (Step S38). The first to third areas stated above are values that decrease in the order of the first area, the second area, and the third area, and these values can be determined as appropriate according to specifications.

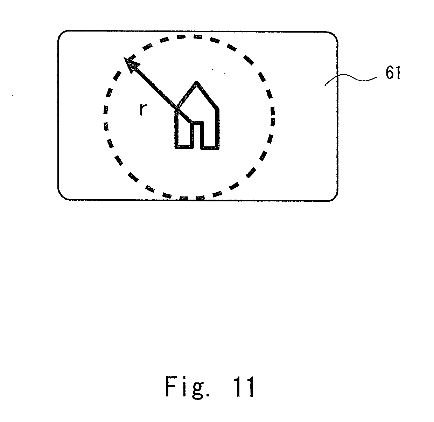

Fig. 11 is a diagram for describing one example of a case in which the size of the icon displayed on the display means 2 is adjusted using the icon display adjustment means 13. As shown in Fig. 11, the icon display adjustment means 13 is able to adjust the size of an icon 61 so that the area of the icon becomes larger than the area of the circle (shown by the dotted line) when the range in which the electrostatic capacitance of the touch panel 1 has changed is approximated by the circle. The circle and the radius r shown in Fig. 11 correspond to the circle 54 and the radius r shown in Fig. 2. In this way, by increasing the area of the icon than the area of the circle shown in Fig. 11, it is possible to prevent the icon from being hidden when the user wears the glove, thereby being able to improve operability of the input device.

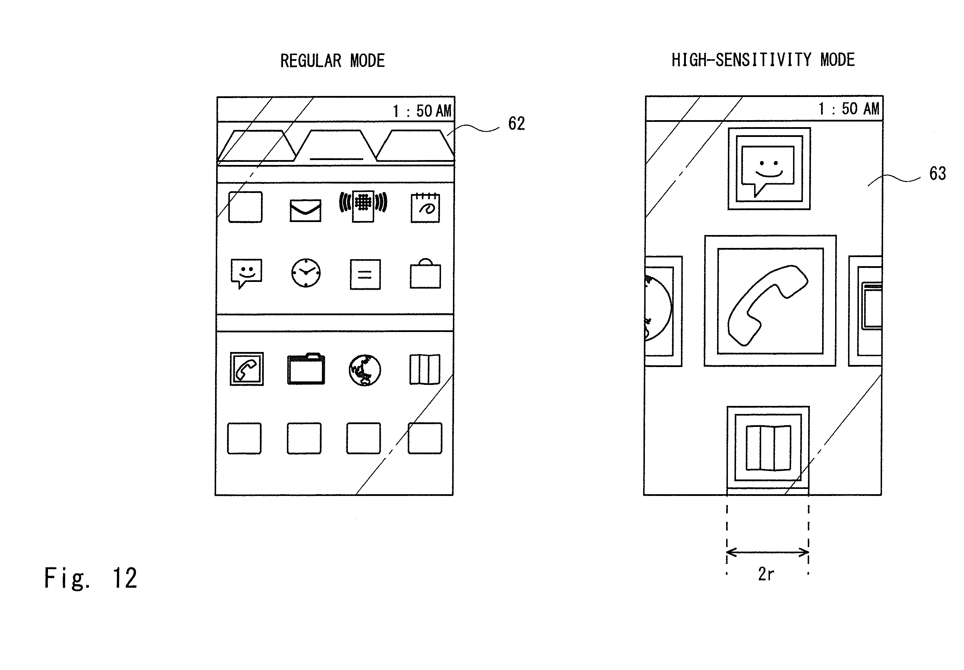

Fig. 12 is a diagram showing specific examples of screens of the input device according to this exemplary embodiment. The left side of Fig. 12 is a screen 62 in the regular-sensitivity mode. Further, the right side of Fig. 12 is a screen 63 in the high-sensitivity mode. As shown in Fig. 12, in the screen 63 in the high-sensitivity mode, icons are displayed to be larger than those in the screen 62 in the regular-sensitivity mode. In this case, the length of one side of each icon may be equal to or larger than the diameter (2r) of the circle 54 shown in Fig. 2.

As stated above, in the input device according to this exemplary embodiment, the size of the icon displayed on the display means 2 is adjusted by being dynamically switched according to the measurement value measured by the measurement means 11. It is therefore possible to suppress such a situation in which the icon displayed on the display means 2 is hidden by the glove and the operability is degraded when a user operates the touch panel with the glove.

### Third exemplary embodiment

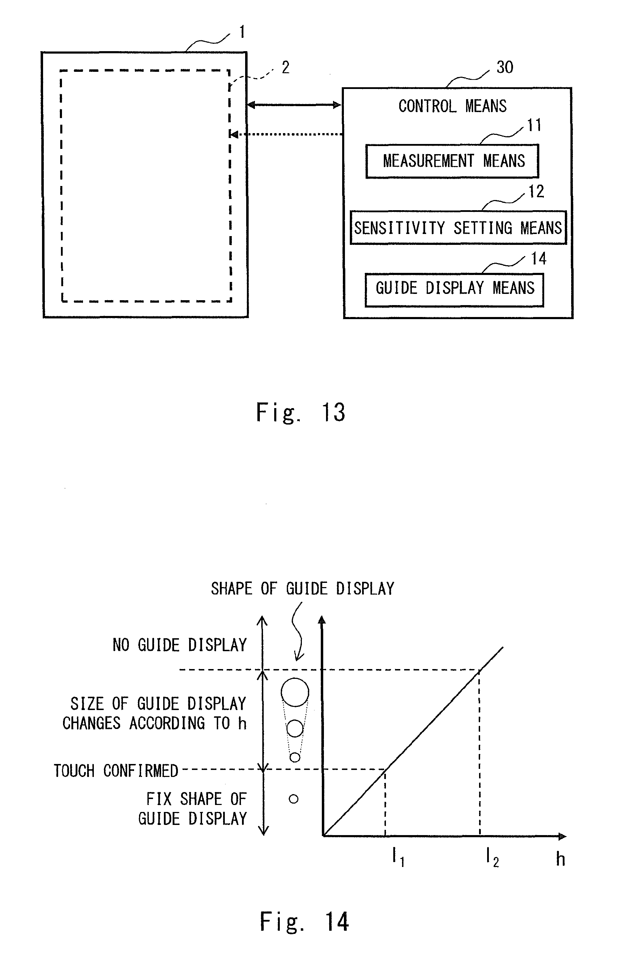

Next, a third exemplary embodiment of the present invention will be described. Fig. 13 is a block diagram showing an input device according to this exemplary embodiment. The input device according to this exemplary embodiment is different from that of the first exemplary embodiment in that a control means 30 according to this exemplary embodiment includes a guide display means 14. Other components are similar to those in the input device according to the first exemplary embodiment, and thus the same components are denoted by the same reference symbols and overlapping description will be omitted.

When a user operates the touch panel 1 with a glove, the area of the tip part of the gloved finger increases, which causes a problem that an icon displayed on the display means 2 is hidden by the glove and the operability is degraded. In order to solve this problem, in the input device according to this exemplary embodiment, the guide display means 14 is used to display a guide display that increases with increasing distance between the touch panel 1 and the finger in proximity to the touch panel 1 on the display means 2.

Specifically, when the gloved finger is in proximity to the touch panel 1 (i.e., the glove is not in touch with the touch panel) and the distance between the gloved finger and the touch panel 1 is relatively large, the guide display means 14 displays a relatively large guide display on the display means 2. The guide display means 14 displays the guide display on the display means 2 so that the size of the guide display decreases with decreasing distance between the gloved finger and the touch panel 1.

Fig. 14 is a diagram showing a relation between a shape of the guide display and a distance (h) between the finger and the touch panel 1. As shown in Fig. 14, the shape of the guide display changes as the distance h between the finger and the touch panel 1 varies between 1₁ and 1₂. In short, the guide display means 14 displays the guide display on the display means 2 so that the size of the guide display increases with increasing distance h from the touch panel 1. In other words, the guide display means 14 displays the guide display on the display means 2 so that the size of the guide display is in proportion to the distance h between the finger and the touch panel 1. The distance h between the finger and the touch panel 1 means a distance between the touch panel 1 and the non-gloved finger. When the thickness of the glove is 1₁ and the distance h between the finger and the touch panel 1 is 1₁, the glove and the touch panel 1 are in contact with each other. In this case, the touch panel 1 recognizes the input by an operation (touch confirmed). Meanwhile, when the distance h between the finger and the touch panel 1 is larger than 1₂, the distance between the finger and the touch panel 1 is too long. In this case, the guide display means 14 does not display the guide on the display means 2.

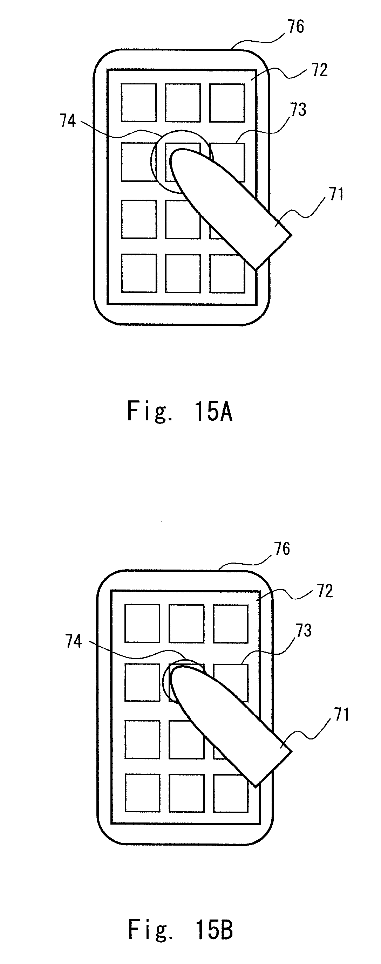

Figs. 15A and 15B are specific examples of screens of the input device according to this exemplary embodiment. In Figs. 15A and 15B, icons 73 and a guide display 74 are displayed in a touch panel 72 included in an input device 76 (display means actually performs display). The input device 76 can be operated with a finger 71. Fig. 15A shows a case in which the distance between the touch panel 1 and the finger 71 is relatively large. In such a case, the size of the guide display 74 is relatively large. For example, the size of the guide display 74 may be larger than that of the icon 73.

Meanwhile, Fig. 15B shows a case in which the distance between the touch panel and the finger is relatively short. In this case, the size of the guide display 74 may be smaller than that of the case shown in Fig. 15A. In this case, for example, the guide display 74 may have about the same size as the icon 73.

As stated above, in the input device according to this exemplary embodiment, the guide display means 14 is used to display the guide display that increases with increasing distance between the touch panel 1 and the finger in proximity to the touch panel 1 on the display means 2. It is therefore possible to provide the input device which can suppress degradation of the operability of the touch panel when a user operates the touch panel 1 with the glove.

### Fourth exemplary embodiment

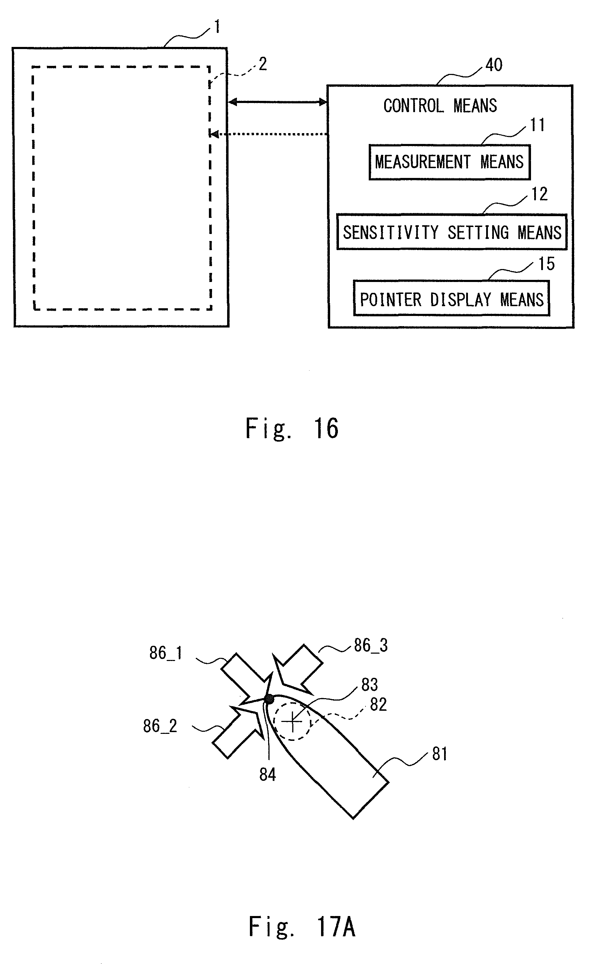

Next, a fourth exemplary embodiment of the present invention will be described. Fig. 16 is a block diagram showing an input device according to this exemplary embodiment. The input device according to this exemplary embodiment is different from that according to the first exemplary embodiment in that a control means 40 according to this exemplary embodiment includes a guide display means 15. Other components are similar to those in the input device according to the first exemplary embodiment, and thus the same components are denoted by the same reference symbols and overlapping description will be omitted.

When a user operates the touch panel 1 with a glove, the area of the tip part of the gloved finger increases, which causes a problem that an icon displayed on the display means 2 is hidden by the glove and the operability is degraded. In order to solve this problem, the input device according to this exemplary embodiment uses the pointer display means 15 to display pointers with the tip part of the finger which operates the touch panel 1 as a center.

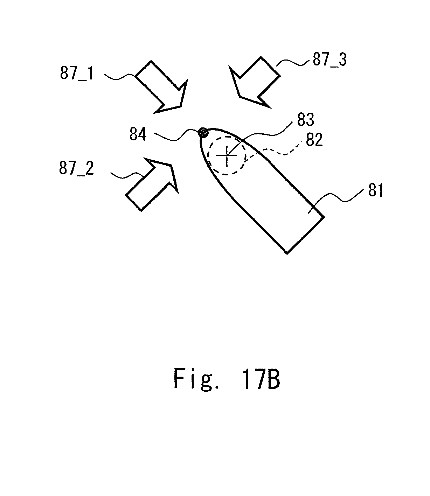

Figs. 17A and 17B are diagrams showing pointers in the input device according to this exemplary embodiment. Fig. 17A shows a case in which the touch panel 1 and the gloved finger are in contact with each other, and Fig. 17B shows a case in which the distance between the touch panel 1 and the gloved finger is long.

When the touch panel 1 and a gloved finger 81 are in contact with each other as shown in Fig. 17A, the pointer display means 15 displays a plurality of pointers 86_1 to 86_3 with a pointer display position 84 separated from the central point of the contact surface between the touch panel 1 and the finger or the glove (i.e., a central point 83 of a circle 82 when the contact surface is approximated by a circle) by a predetermined interval as a center. The circle 82 corresponds to the circle 54 shown in Fig. 2. In this way, the pointer display means 15 is used to display the plurality of pointers 86_1 to 86_3 with the tip part (pointer display position 84) of the finger which operates the touch panel 1 as a center, thereby being able to improve the operability of the touch panel.

Further, when the touch panel 1 and the gloved finger 81 are in proximity to each other (when they are not in contact with each other) as shown in Fig. 17B, the pointer display means 15 displays a plurality of pointers 87_1 to 87_3 so that they are away from the pointer display position 84 with increasing distance between the touch panel 1 and the finger 81 in proximity to the touch panel 1. In this way, by displaying the plurality of pointers 87_1 to 87_3 using the pointer display means 15, it is possible to clearly indicate the pointer display position 84, which enables to improve the operability of the touch panel.

In the examples shown in Figs. 17A and 17B, the plurality of pointers 86_1 to 86_3 and 87_1 to 87_3 are displayed with the pointer display position 84 as a center. However, the positions and the shapes of the pointers are not limited to those in the cases shown in Figs. 17A and 17B but may be determined as appropriate. Further, while described above is the case in which the plurality of pointers are used, only one pointer may be used. For example, the guide display according to the third exemplary embodiment may be displayed with the pointer display position 84 as a center.

Further, in the examples shown in Figs. 17A and 17B, by displaying the pointers in the positions opposed to the pointers 86_1 and 87_1 (i.e., the positions hidden by the finger 81), for example, it is possible to display three pointers even when a user with different dominant hand uses the touch panel. Specifically, when a left-handed user uses the touch panel, the pointers 86_2 and 87_2 shown in Figs. 17A and 17B are hidden by a finger. Even in this case, however, it is possible to use the pointers displayed in the positions opposed to the pointers 86_1 and 87_1.

As described above, in the input device according to this exemplary embodiment, the pointer display means 15 is used to display pointers with the tip part (pointer display position 84) of the finger which operates the touch panel 1 as a center. This enables to clearly indicate the pointer display position 84, which is able to suppress degradation of the operability of the touch panel 1 when the user operates the touch panel 1 with his or her gloved hand.

The input device according to the present invention may be used, for example, in mobile equipment such as smartphones, or may be used in fixed-type input terminals. Furthermore, the first to fourth exemplary embodiments may be combined as appropriate.

Furthermore, the input device according to the present invention described above may be achieved by storing a program which achieves the aforementioned processing in a memory or the like of the input device and executing the program by a processing device or the like. The program that causes a computer to execute processing of controlling the touch panel according to the present invention is a program for causing a computer to execute processing of measuring the measurement value corresponding to the situation whether a glove is worn and the thickness of the glove and setting the sensitivity of the touch panel according to the measurement value that is measured.

While the present invention has been described according to the exemplary embodiments stated above, it is needless to say that the present invention is not limited to the configurations in the aforementioned exemplary embodiments but includes various changes, modifications, or combinations that can be made by those skilled in the art within the scope of the invention set forth in claims of the present application.

While a part or all of the aforementioned exemplary embodiments may be described as shown in the following Supplementary notes, it is not limited to them.

### (Supplementary note 1)

An input device comprising:
a touch panel;
a display means provided to be superimposed on the touch panel;
a measurement means that is able to measure a measurement value corresponding to a situation whether a glove is worn and a thickness of the glove; and
a sensitivity setting means configured to set sensitivity of the touch panel according to the measurement value measured by the measurement means.

### (Supplementary note 2)

The input device according to Supplementary note 1, wherein
the measurement value is a first value corresponding to a range in which an electrostatic capacitance of the touch panel has changed, and
the sensitivity setting means increases the sensitivity of the touch panel as the first value increases.

### (Supplementary note 3)

The input device according to Supplementary note 2, wherein
the first value is a radius or a diameter of a circle when the range in which the electrostatic capacitance of the touch panel has changed is approximated by the circle, and
the sensitivity setting means increases the sensitivity of the touch panel as the radius or the diameter increases.

### (Supplementary note 4)

The input device according to Supplementary note 1, wherein
the measurement value is a second value corresponding to a maximum value of the electrostatic capacitance of the touch panel, and
the sensitivity setting means increases the sensitivity of the touch panel as the second value decreases.

### (Supplementary note 5)

The input device according to any one of Supplementary notes 1 to 4, wherein the sensitivity setting means sets the sensitivity of the touch panel to a regular-sensitivity mode in a case in which the glove is not worn, and sets the sensitivity of the touch panel to a high-sensitivity mode in a case in which the glove is worn, the high-sensitivity mode being more sensitive than the regular-sensitivity mode.

### (Supplementary note 6)

The input device according to Supplementary note 5, wherein the sensitivity setting means sets the sensitivity of the touch panel to the high-sensitivity mode when the measurement means measures the measurement value.

### (Supplementary note 7)

The input device according to any one of Supplementary notes 1 to 6, wherein the measurement means measures the measurement value when an operation of releasing a locked state in which an input from the touch panel is locked is executed.

### (Supplementary note 8)

The input device according to any one of Supplementary notes 1 to 7, further comprising an icon display adjustment means configured to adjust a size of an icon displayed on the display means according to the measurement value measured by the measurement means.

### (Supplementary note 9)

The input device according to Supplementary note 8, wherein the icon display adjustment means adjusts the size of the icon displayed on the display means so that the size of the icon increases as the first value corresponding to the range in which the electrostatic capacitance of the touch panel has changed increases.

### (Supplementary note 10)

The input device according to Supplementary note 8, wherein the icon display adjustment means adjusts the size of the icon so that an area of the icon becomes larger than an area of the circle when the range in which the electrostatic capacitance of the touch panel has changed is approximated by the circle.

### (Supplementary note 11)

The input device according to Supplementary note 8, wherein the icon display adjustment means adjusts the size of the icon displayed on the display means so that the size of the icon increases as the second value corresponding to the maximum value of the electrostatic capacitance of the touch panel decreases.

### (Supplementary note 12)

The input device according to any one of Supplementary notes 1 to 11, further comprising a guide display means configured to display a guide display on the display means, the guide display increasing as a distance between the touch panel and a finger in proximity to the touch panel becomes longer.

### (Supplementary note 13)

The input device according to any one of Supplementary notes 1 to 12, further comprising a pointer display means configured to display a pointer with a pointer display position as a center, the pointer display position being separated from a central point of a contact surface between the touch panel and the finger or the glove by a predetermined interval.

### (Supplementary note 14)

The input device according to Supplementary note 13, wherein the pointer display means displays the pointer so that the pointer is away from the pointer display position as the distance between the touch panel and the finger in proximity to the touch panel increases.

### (Supplementary note 15)

A control method of a touch panel comprising:
measuring a measurement value corresponding to a situation whether a glove is worn and a thickness of the glove; and
setting sensitivity of the touch panel according to the measurement value that is measured.

### (Supplementary note 16)

The control method of the touch panel according to Supplementary note 15, wherein
the measurement value is a first value corresponding to a range in which an electrostatic capacitance of the touch panel has changed, and
the sensitivity of the touch panel is increased as the first value increases.

### (Supplementary note 17)

The control method of the touch panel according to Supplementary note 16, wherein
the first value is a radius or a diameter of a circle when the range in which the electrostatic capacitance of the touch panel has changed is approximated by the circle, and
the sensitivity of the touch panel is increased as the radius or the diameter increases.

### (Supplementary note 18)

The control method of the touch panel according to Supplementary note 15, wherein
the measurement value is a second value corresponding to a maximum value of the electrostatic capacitance of the touch panel, and
the sensitivity of the touch panel is increased as the second value decreases.

### (Supplementary note 19)

The control method of the touch panel according to any one of Supplementary notes 15 to 18, comprising adjusting a size of an icon displayed on a display means according to the measurement value that is measured.

### (Supplementary note 20)

The control method of the touch panel according to any one of Supplementary notes 15 to 19, comprising displaying a guide display on the display means, the guide display increasing as a distance between the touch panel and a finger in proximity to the touch panel becomes longer.

### (Supplementary note 21)

The control method of the touch panel according to any one of Supplementary notes 15 to 20, comprising displaying a pointer with a pointer display position as a center, the pointer display position being separated from a central point of a contact surface between the touch panel and the finger or the glove by a predetermined interval.

### (Supplementary note 22)

The control method of the touch panel according to Supplementary note 21, comprising displaying the pointer so that the pointer is away from the pointer display position as the distance between the touch panel and the finger in proximity to the touch panel increases.

This application is based upon and claims the benefit of priority from Japanese Patent Application No. 2011-130288, filed on June 10, 2011, the disclosure of which is incorporated herein in its entirety by reference.

### Reference Signs List

- 1: TOUCH PANEL
- 2: DISPLAY MEANS
- 5: INSULATION FILM
- 6: TRANSPARENT ELECTRODE PATTERN LAYER
- 7: HAND
- 8: GLOVE (THIN ONE)
- 9: GLOVE (THICK ONE)
- 10, 20, 30, 40: CONTROL MEANS
- 11: MEASUREMENT MEANS
- 12: SENSITIVITY SETTING MEANS
- 13: ICON DISPLAY ADJUSTMENT MEANS
- 14: GUIDE DISPLAY MEANS
- 15: POINTER DISPLAY MEANS

## Claims

1. An input device comprising:
a touch panel;
a display means provided to be superimposed on the touch panel;
a measurement means that is able to measure a measurement value corresponding to a situation whether a glove is worn and a thickness of the glove; and
a sensitivity setting means configured to set sensitivity of the touch panel according to the measurement value measured by the measurement means.

2. The input device according to Claim 1, wherein
the measurement value is a first value corresponding to a range in which an electrostatic capacitance of the touch panel has changed, and
the sensitivity setting means increases the sensitivity of the touch panel as the first value increases.

3. The input device according to Claim 2, wherein
the first value is a radius or a diameter of a circle when the range in which the electrostatic capacitance of the touch panel has changed is approximated by the circle, and
the sensitivity setting means increases the sensitivity of the touch panel as the radius or the diameter increases.

4. The input device according to Claim 1, wherein
the measurement value is a second value corresponding to a maximum value of the electrostatic capacitance of the touch panel, and
the sensitivity setting means increases the sensitivity of the touch panel as the second value decreases.

5. The input device according to any one of Claims 1 to 4,
wherein the sensitivity setting means sets the sensitivity of the touch panel to a regular-sensitivity mode in a case in which the glove is not worn, and sets the sensitivity of the touch panel to a high-sensitivity mode in a case in which the glove is worn, the high-sensitivity mode being more sensitive than the regular-sensitivity mode.

6. The input device according to any one of Claims 1 to 5,
wherein the measurement means measures the measurement value when an operation of releasing a locked state in which an input from the touch panel is locked is executed.

7. The input device according to any one of Claims 1 to 6, further comprising an icon display adjustment means configured to adjust a size of an icon displayed on the display means according to the measurement value measured by the measurement means.

8. The input device according to any one of Claims 1 to 7, further comprising a guide display means configured to display a guide display on the display means, the guide display increasing as a distance between the touch panel and a finger in proximity to the touch panel becomes longer.

9. The input device according to any one of Claims 1 to 8, further comprising a pointer display means configured to display a pointer with a pointer display position as a center, the pointer display position being separated from a central point of a contact surface between the touch panel and the finger or the glove by a predetermined interval.

10. A control method of a touch panel comprising:
measuring a measurement value corresponding to a situation whether a glove is worn and a thickness of the glove; and
setting sensitivity of the touch panel according to the measurement value that is measured.
